# EUROPEAN PATENT SPECIFICATION

(11) **EP 3 391 418 B1**
(45) Date of publication and mention of the grant of the patent: **16.11.2022**
(21) Application number: 16825878.8
(22) Date of filing: 14.12.2016
(51) Int. Cl.: H01L 31/02, H01L 31/0463, H01L 31/0465, H01L 31/048

(54) **SOLAR MODULE BUSBAR**
SOLARMODUL-SAMMELSCHIENE
BARRE OMNIBUS DE MODULE SOLAIRE

(30) Priority: 15.12.2015 US 201562267670 P
(43) Date of publication of application: 24.10.2018
(73) Proprietor: Flisom AG, 8155 Niederhasli (CH)
(72) Inventor: KRETSCHMER, Sebastian, 8118 Pfaffhausen (CH)
(86) International application number: PCT/IB2016/001765
(87) International publication number: WO 2017/103664

(56) References cited:
- EP-A1- 2 669 954
- WO-A1-2013/040036
- WO-A1-2015/029657
- WO-A1-2015/114498
- US-A1- 2016 064 587

## Description

### BACKGROUND

### Field

Embodiments of the present disclosure generally relate to electrical connection components used in a photovoltaic apparatus and methods of using or forming the same.

### Description of the Related Art

Photovoltaic apparatuses generally include one or more arrays of photovoltaic cells arranged between a pair of busbars. The busbars are generally connected between the photovoltaic cells and a junction box that is used to make external electrical connections to the photovoltaic apparatus. The busbars may be encapsulated in positions disposed over opposing ends of the one or more arrays of photovoltaic cells.

Photovoltaic apparatuses are often placed outside and can thus be exposed to a large range of temperatures, wind generated loads and/or loads applied by collected snow. Large changes in temperature can cause stress in a photovoltaic apparatus as different components expand and contract at different rates. These wind, snow and/or temperature generated stresses can result in deformations around the busbars that can affect the electrical contact between the busbars and portions of a photovoltaic device, and lower the efficiency of the photovoltaic apparatus. The induced stresses may also result in delaminating of layers in the photovoltaic apparatus. Delaminating can expose the interior of the photovoltaic apparatus to moisture, humidity, and other substances found in the external environment which can damage (e.g., corrode) portions of photovoltaic devices disposed within the interior of the photovoltaic apparatus.

Therefore, there is a need for an improved photovoltaic apparatus that can reduce the undesirable effects of wind, snow, temperature or other induced stresses on a photovoltaic apparatus as well as a method for producing such a photovoltaic apparatus.

WO2015029657 discloses a photovoltaic device having a busbar electrode having a zigzag or wavy form to improve the quality of busbars and fingers emanating from the busbars when simultaneously formed by a screen printing process. Although WO2015029657 discloses a solution to improve the quality of the manufacturing process, there is no indication that the presented solution improves the device's longevity when subjected to environmentally-induced stresses. Therefore, there is a need for an improved photovoltaic apparatus that can reduce the undesirable effects of wind, snow, temperature or other induced stresses on a photovoltaic apparatus as well as a method for producing such a photovoltaic apparatus.

### SUMMARY

Embodiments of the present disclosure generally relate to electrical connecting components, such as a busbar, used in a thin-film photovoltaic apparatus.

The invention is set out in the appended set of claims.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope, and may admit to other equally effective embodiments.
Figure 1A is a partial cross sectional view of a photovoltaic apparatus, according to an embodiment.
Figure 1B is a top cross sectional view of the photovoltaic apparatus of Figure 1A through the section line 1B of Figure 1A, according to one embodiment.
Figure 2A is a top view of the dashed box 1 of Figure 1B that includes a first embodiment of a first busbar, according to one embodiment.
Figure 2B is a side sectional view along the section line 2-2 of Figure 2A, according to one embodiment.
Figure 2C is an alternative side sectional view along the section line 2-2 of Figure 2A, according to one embodiment.
Figure 2D is an alternative side sectional view along the section line 2-2 of Figure 2A, according to one embodiment.
Figure 3A is a top view of the dashed box 1 of Figure 1B that includes a second embodiment of a first busbar, according to one embodiment.
Figure 3B is a side sectional view along the section line 3B of Figure 3A, according to one embodiment.
Figure 4A is a top view of the dashed box 1 of Figure 1B that includes a third embodiment of a first busbar, according to one embodiment.
Figure 4B is a side sectional view along the section line 4B of Figure 4A, according to one embodiment.
Figure 5A is a partial top view of two vias that may be included in the photovoltaic apparatus, according to one embodiment.
Figure 5B is a side sectional view of the along the section line 5B of Figure 5A, according to one embodiment.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments of the present disclosure generally relate to a thin-film photovoltaic apparatus, and more particularly to an apparatus and method of structuring the front sheet of a thin-film photovoltaic apparatus.

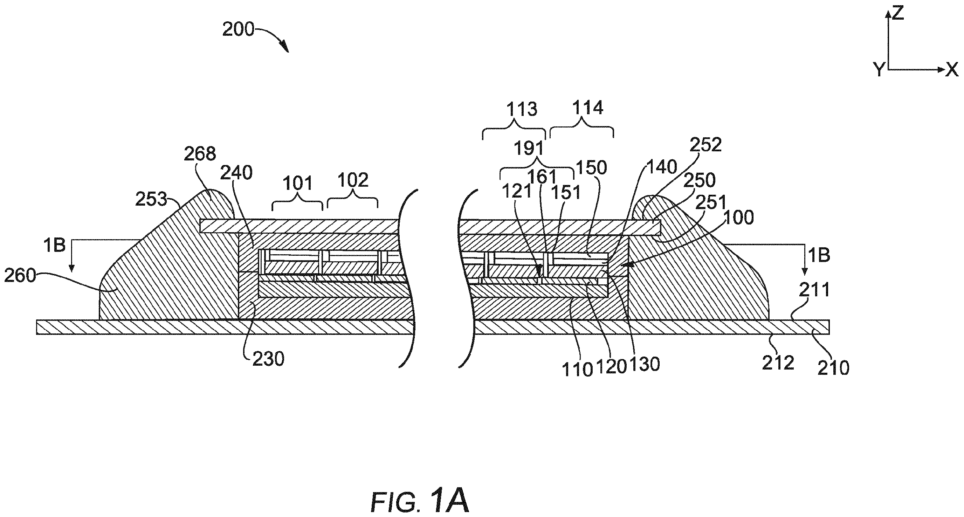

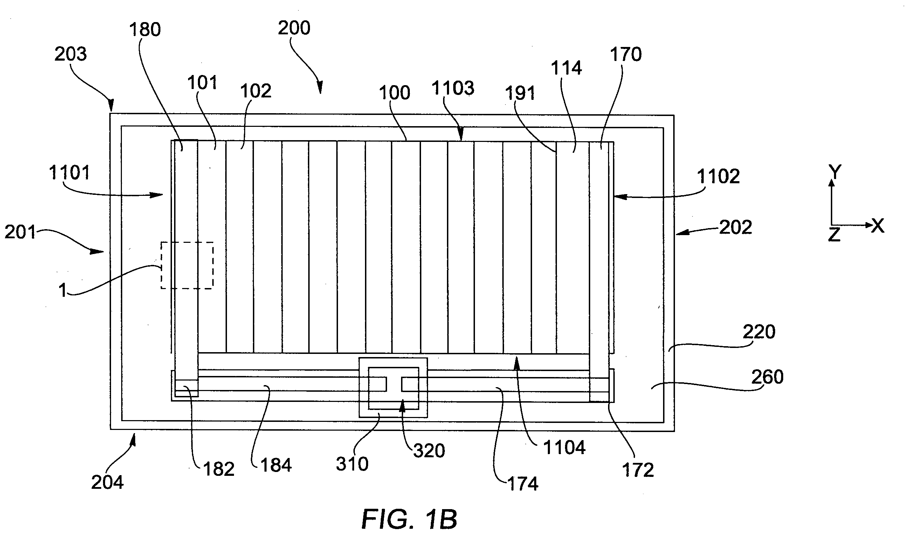

Figure 1A is a partial cross sectional view of a photovoltaic apparatus 200, according to an embodiment of the disclosure provided herein. Figure 1B is a top cross sectional view of the photovoltaic apparatus 200 through the section line 1B of Figure 1A. The photovoltaic apparatus 200 is shown in Figure 1B without a front-side adhesive 240 , a back-side adhesive 230, and portions of an edge seal 260 (described below in reference to Figure 1A) to more clearly show the components in the photovoltaic apparatus 200. The photovoltaic apparatus 200 may include multiple optoelectronic devices, such as photovoltaic devices, diodes, and LEDs. As illustrated in Figure 1B, the photovoltaic apparatus 200 extends from a first end 201 to a second end 202 in the X-direction (the first direction). The photovoltaic apparatus 200 also extends from a first side 203 to a second side 204 in the Y-direction (the second direction).

The views in Figures 1A and 1B of the photovoltaic apparatus 200 are shown including a photovoltaic device 100 (or sub-module) including an array of fourteen photovoltaic cells 101-114, the array extending from a first end 1101 of the photovoltaic device 100 to a second end 1102 of the photovoltaic device 100 in the X-direction. More or fewer photovoltaic cells may be included as required by the electrical generation application in which the photovoltaic device(s) will be used. The individual photovoltaic cells, such as photovoltaic cell 101, extend from a first side 1103 to a second side 1104 of the photovoltaic device 100 in the Y-direction.

The photovoltaic cells 101-114 are spaced apart in the X-direction and consecutive photovoltaic cells (e.g., 101, 102) are interconnected to each other by a plurality of serial interconnects 191 (i.e., also referred to as P1, P2 and P3 scribe lines), that extend in the Y-direction. The layers of each photovoltaic cell 101-114, such as layers 120-150 (described in fuller detail below), are formed in a stacked orientation in the Z-direction. (the third direction). In some applications, the photovoltaic cells 101-114 may also be isolated from additional photovoltaic cells (not shown) that are separated from each other in the Y-direction due to an X-direction isolation scribe line (not shown) that separates the photovoltaic cells to form an X-Y array of photovoltaic cells.

The photovoltaic cells (e.g., photovoltaic cells 101, 102) are electrically connected in series between bus bars 180, 170 by use of the formed serial interconnects 191. The photovoltaic device 100 is formed on a substrate 110. The substrate 110 may be a rigid substrate or a flexible substrate. The substrate 110 may also be formed from an electrically insulating material. For example, in one embodiment a polyimide substrate may be used.

An electrically conductive back-contact layer 120 may be disposed on a surface of the substrate 110. Back-contact layer 120 can be fabricated from a material having a high optical reflectance and is commonly made of molybdenum (Mo) although several other thin-film materials, such as metal chalcogenides, molybdenum chalcogenides, molybdenum selenides (such as MoSe₂), sodium (Na)-doped Mo, potassium (K)-doped Mo, Na- and K-doped Mo, transition metal chalcogenides, tin-doped indium oxide (ITO), doped or non-doped indium oxides, doped or non-doped zinc oxides, zirconium nitrides, tin oxides, titanium nitrides, titanium (Ti), tungsten (W), tantalum (Ta), gold (Au), silver (Ag), copper (Cu), and niobium (Nb) may also be used or included advantageously. In some embodiments, the back-contact layer 120 is deposited onto the substrate 110 by use of sputtering process.

At least one absorber layer 130 is disposed on the back-contact layer 120. Absorber layer 130 is typically made of an "ABC" material, wherein "A" represents elements in group 11 of the periodic table of chemical elements as defined by the International Union of Pure and Applied Chemistry including copper (Cu) or silver (Ag), "B" represents elements in group 13 of the periodic table including indium (In), gallium (Ga), or aluminum (Al), and "C" represents elements in group 16 of the periodic table including sulfur (S), selenium (Se) or tellurium (Te). An example of an ABC material is the Cu(In,Ga)Se₂ semiconductor also known as CIGS. In some embodiments, the absorber layer 130 may be a polycrystalline material. In other' embodiments, the absorber layer 130 may be a monocrystalline material.

A semiconductive buffer layer 140 can be disposed on the absorber layer 130. The semiconductive buffer layer 140 ordinarily has an energy bandgap higher than 1.5 eV. The semiconductive buffer layer 140 may be formed of materials, such as CdS, Cd(S,OH), CdZnS, indium sulfides, zinc sulfides, gallium selenides, indium selenides, compounds of (indium, gallium)-sulfur, compounds of (indium, gallium)-selenium, tin oxides, zinc oxides, Zn(Mg,O)S, Zn(O,S) material, or variations thereof.

A front-contact layer 150 may be disposed on the semiconductive buffer layer 140. The front-contact layer 150 can be an electrically conductive and optically transparent material, such as a transparent conductive oxide (TCO) layer. For example, in some embodiments, the front-contact layer 150 may be formed of doped or non-doped variations of materials, such as indium oxides, tin oxides, or zinc oxides.

The first busbar 180 forms an electrical connection to the back-contact layer 120 of the first photovoltaic cell 101. The first busbar 180 may form the cathode of the photovoltaic device 100. In some embodiments, the first busbar 180 may be formed of a flexible material.

The second busbar 170 forms an electrical connection to the front-contact layer 150 of the fourteenth photovoltaic cell 114. The second busbar 170 may form the anode of the photovoltaic device 100. In some embodiments, the second busbar 170 may be formed of a flexible material.

The serial interconnect 191 forms an electrical connection between each consecutive photovoltaic cell 101-114 in the array. Each serial interconnect 191 includes a connecting groove 161 (i.e., the P2 scribe line) that is formed through the front-contact layer 150, the semiconductive buffer layer 140 and the absorber layer 130 to form an electrically conductive path that electrically serially connects consecutive photovoltaic cells in the array. The conductive path may be formed by melting a portion of the absorber layer 130 during a laser scribing process used to form the connecting groove 161. For example, one connecting groove 161 electrically connects the front-contact layer 150 of the third photovoltaic cell 103 to the back-contact layer 120 of the fourth photovoltaic cell 104.

In some embodiments, each serial interconnect 191 includes a pair of grooves to electrically isolate portions of each adjacent photovoltaic cell. A back-contact groove 121 (i.e., the P1 scribe line) electrically isolates back-contact layers 120 of adjacent photovoltaic cells, such as photovoltaic cells 113, 114 from each other. A front-contact groove 151 (i.e., the P3 scribe line) electrically isolates front-contact layers 150 of adjacent photovoltaic cells, such as photovoltaic cells 113, 114 from each other. The serial interconnects 191 collectively electrically connect the photovoltaic cells 101-114 in series.

The photovoltaic device 100 may be encapsulated within the photovoltaic apparatus 200 by use of a front-side adhesive 240 and a back-side adhesive 230. In some embodiments, the front-side adhesive 240 and the back-side adhesive 230 completely surround the photovoltaic device 100. The front-side adhesive 240 is formed over the front-contact layer 150 of each of the photovoltaic cells 101-114 of the photovoltaic device 100, and also over the first and second busbars 180, 170. In some embodiments, it is desirable for the front-side adhesive 240 to also fill the front contact grooves 151 between the front-contact layers 150 of the different photovoltaic cells 101-114. The front-side adhesive 240 can also surround all of the edges of the photovoltaic device 100 (i.e., the ends 1101, 1102, and the sides 1103, 1104). The front-side adhesive 240 may be formed of a flexible material, such as a flexible polymer. For example, in one embodiment the front-side adhesive 240 may be formed of a thermoplastic olefin-(TPO) based polymer.

The back-side adhesive 230 is formed on the side of the substrate 110 opposite to the photovoltaic device 100. The back-side adhesive 230 can also surround all of the edges of the photovoltaic device 100 (i.e., the ends 1101, 1102, and the sides 1103, 1104). The back-side adhesive 230 may be formed of a flexible material, such as a flexible polymer. For example, in one embodiment the back-side adhesive 230 may be formed of a thermoplastic olefin-based polymer (TPO). The back-side adhesive 230 may contact the front side adhesive 240 at each end 1101, 1102 of the photovoltaic device 100 and also on either side 1103, 1104 of the photovoltaic device 100, so that the front-side adhesive 240 and the back-side adhesive 230 completely surround and encapsulate the photovoltaic device 100.

A back sheet 210 can be disposed on an outer surface of the back-side adhesive 230, such as a bottom surface of the back-side adhesive 230. The back sheet 210 can be formed of a reflective material, such as a metal or a reflective polymer. In some embodiments, the back sheet 210 may be formed of a rigid material. In other embodiments, the back sheet 210 may be formed of a flexible material. In some embodiments, a fiber-reinforced polymer may be used as the material for the back sheet 210. In still other embodiments, the back sheet 210 may be formed of glass material. The back sheet 210 has a first surface 211 facing the photovoltaic device 100, and a second surface 212 opposite to the first surface 211.

A front sheet 250 can be disposed on an outer surface of the front-side adhesive 240, such as a top surface of the front-side adhesive 240. The front sheet 250 can be formed of a flexible, transparent material, such as a transparent thermoplastic polymer. The front sheet 250 has a first surface 251 facing the photovoltaic device 100, and a second surface 252 opposite to the first surface 251. The front sheet 250 further includes an outer edge 253 that extends from the first surface 251 to the second surface 252.

The photovoltaic apparatus 200 further includes an edge seal 260 disposed between the front sheet 250 and the back sheet 210. The edge seal 260 can fill a region between the front sheet 250 and the back sheet 210 to create a seal for protecting the interior of the photovoltaic apparatus 200 from the environment. An inner surface (i.e., a surface facing the photovoltaic device 100) of each edge seal 260 may contact the front-side adhesive 240 and the back-side adhesive 230. The edge seal 260 may be formed of a polymer material, such as butyl.

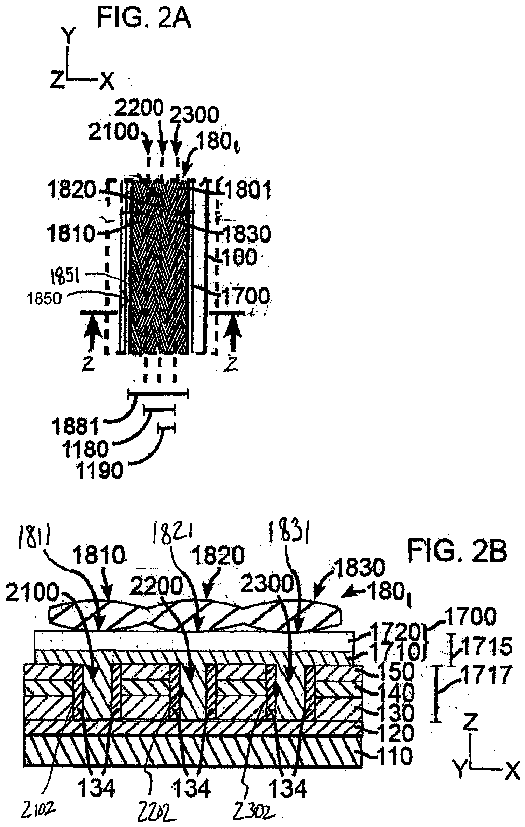

The seal 260 extends from the first surface 211 of the back sheet 210 past the outer edge 253 of the front sheet 250 to contact the second surface 252 of the front sheet 250. The edge seal 260 includes a front overlap 268 that extends past the second surface 252 of the front sheet 250 in the Z-direction. The front overlap 268 extends in the X-direction towards a center of the photovoltaic apparatus 200 in the X-direction. The presence of the front overlap 268 of the edge seal 260 forms an extended path length that the externally supplied contaminants would need to bridge or cross during normal device operation to cause photovoltaic device failure. The front overlap 268 may provide better overall adhesive properties to the edge seal 260. These better overall adhesive properties may provide a longer lifetime to the edge seal 260, for example in the context of the daily thermal cycling to which photovoltaic devices may be exposed. The presence of the front overlap 268 can thus help assure that photovoltaic apparatus 200 will meet electrical certification requirements and improve the device lifetime by eliminating a common photovoltaic apparatus failure mode. In some embodiments, the front overlap 268 extends in the X-direction to at least partially overlie the busbar 180, 170. In some embodiments, the front overlap 268 extends in the X-direction to fully overlie the busbar 180, 170. In general, the edge seal 260 comprises a polymeric material, such as an elastomer, for example a butyl rubber that can be formed by dispensing a liquid precursor material along the edge of the photovoltaic apparatus 200 and allowing it to cure. The release sheet 300 (Figures 2A, 2B) can further be used to mold the edge seal 260 so that a stronger seal can be formed as described in fuller detail below.

The photovoltaic apparatus 200 may further include an opening 320 extending through the back sheet 210. The opening 320 may be used to route one or more conductors to electrically connect the photovoltaic apparatus 200 to one or more external devices, such as electronics to charge one or more external batteries. A junction box (not shown) may be positioned over the opening 320. The junction box may contact the second surface 212 of the back sheet 210.

A first junction busbar 182 can extend from the junction box through the opening 320 and to the first busbar 180 allowing for an electrical connection to be made to the first busbar 180 in the junction box. In some embodiments, the first junction busbar 182 may be formed of a flexible material, such as a thin metal strip that has a thickness oriented in the Z-direction. Furthermore, in some embodiments, a conductive adhesive can be used to paste the first junction busbar 182 to the first busbar 180. In other embodiments, the first busbar 180 and the first junction busbar 182 may be welded or soldered together. In still other embodiments, the first junction busbar 182 can be a folded continuation of the first busbar 180. In some embodiments, a first junction busbar insulation 184 can be formed around the first junction busbar 182 to electrically insulate the first junction busbar 182. The first junction busbar insulation 184 can be formed of, for example, a polytetrafluoroethylene (PTFE) heat-shrink tubing or a silicon rubber coated fiberglass tube.

A second junction busbar 172 can extend from the junction box through the opening 320 and to the second busbar 170 allowing for an electrical connection to be made to the second busbar 170 in the junction box. In some embodiments, the second junction busbar 172 may be formed of a flexible material, such as a thin metal strip that has a thickness oriented in the Z-direction. Furthermore, in some embodiments, a conductive adhesive can be used to paste the second junction busbar 172 to the second busbar 170. In other embodiments, the second junction busbar 172 and the second busbar 170 may be welded together. In still other embodiments, the second junction busbar 172 can be a folded continuation of the second busbar 170. In some embodiments, a second junction busbar insulation 174 can be formed around the second junction busbar 172 to electrically insulate the second junction busbar 172. The second junction busbar insulation 174 can be formed of, for example, a polytetrafluoroethylene (PTFE) heat-shrink tubing or a silicon rubber coated fiberglass tube.

The photovoltaic apparatus 200 can further include a sealing assembly 310 to seal the opening 320. The sealing assembly 310 can include one or more layers formed over the back sheet 210, where one or more of the layers may be formed on the back sheet 210. The one or more layers of the sealing assembly 310 can be formed of a polymeric material, such as an elastomer, for example a butyl rubber.

Figure 2A is a top view of the dashed box 1 of Figure 1B that includes a first embodiment the first busbar 180 shown here as first busbar 180₁, according to one embodiment. Figure 2B is a side sectional view along the section line 2-2 of Figure 2A, according to one embodiment. Although Figures 2A-4B illustrate additional detail for the first busbar 180, this additional detail can also apply to the second busbar 170 where applicable. For example, one of the main differences between the first busbar 180 and the second busbar 170 is that the first busbar 180 is electrically connected to the back-contact layer 120 while the second busbar 170 may be electrically connected to directly to the front-contact layer 150. However, in some embodiments, the second busbar 180 may alternately be electrically connected to an electrically isolated portion of the front-contact layer 150 that is electrically coupled to a desired portion of the back-contact layer 120 by use of a conductive paste (not shown) and/or melted regions of the thin film layers formed during a scribing process. Thus, these connections between the respective busbars 180, 170 and the respective layers 120, 150 may be different, but the actual busbar 180, 170 can take identical forms. Furthermore, because both busbars 180, 170 are disposed over the front-contact layer 150, any layers or components between the busbars 180, 170 and the front-contact layer 150 may also be the same around each busbar 180, 170.

Referring to Figure 2B, the photovoltaic apparatus 200 includes a first via 2100, a second via 2200, and a third via 2300 to electrically connect portions of the first busbar 180₁ to portions of the back-contact layer 120. Each via 2100, 2200, 2300 is disposed between the first busbar 180₁ and the back-contact layer 120. The vias 2100, 2200, 2300 are spaced apart from each other in the X-direction. Furthermore, the vias 2100, 2200, 2300 extend in the Y-direction as shown in Figure 2A, for example, for substantially the whole length of the busbar 180₁ in the Y-direction. A centerline of the first via 2100 in the X-direction may be spaced apart from a centerline of the last via (i.e., the third via 2300) in the X-direction by a distance 1180 that can be from about 100 µm to about 3 cm, such as from about 2 mm to about 8 mm, such as from about 3 mm to about 5 mm. A centerline of the adjacent vias (e.g., the first via 2100 and the second via 2200) may be spaced apart in the X-direction by a distance 1190 that can be from about 60 µm to about 3 mm, such as from about 200 µm to about 1 mm, such as from about 500 µm to about 800 µm. The vias 2100, 2200, 2300 may have a thickness 1717 in the Z-direction from about 2 µm to about 6 µm, such as from about 3 µm to about 5 µm.

In some embodiments, the vias 2100, 2200, 2300 may be spaced apart from other vias (not shown) in the Y-direction. For example, a series of vias (not shown) may be aligned with each of the vias 2100, 2200, 2300 in the X-direction, where each of the series extends for substantially the whole length of the busbar 180₁ in the Y-direction. For embodiments including a series of vias spaced apart in the Y-direction, the vias 2100, 2200, 2300 may have a length in the Y-direction from about 50 µm to about 100 mm, such as from about 50 µm to about 1 mm, such as from about 180 µm to about 220 µm. Furthermore, these vias may be spaced apart in the Y-direction by about 10 µm to about 1000 µm, such as by about 10 µm to about 100 µm, such as by about 40 µm to about 60 µm.

The vias 2100, 2200, 2300 may be formed by removing portions of the absorber layer 130, buffer layer 140, and front-contact layer 150 during a laser scribing process to form respective openings 2102, 2202, and 2302, and then filling the openings 2102, 2202, and 2302 with a conductive material, such as the conductive ink or metal containing paste (e.g., Ag, Sn/Pb alloys, etc. paste) also used for the first conductive layer 1710 described below.

This laser scribing process can also make walls 134 of the openings 2102, 2202, 2302 conductive. The laser scribing process can melt portions of the layers 130-150 to form the conductive walls 134 by, for example, melting the materials used to form the pn junctions, which were present before the laser scribing process. In some embodiments, the walls 134 can be formed of a copper rich alloy, such as copper rich CIGS alloy. Furthermore, in some embodiments, the openings 2102, 2202, 2302 can extend further down in the Z-direction by removing some of the back-contact layer 120 during the laser scribing process or enough of the back-contact layer 120 so that the openings 2102, 2202, 2302 can extend down to the substrate 110. Using the plurality of openings 2102, 2202, 2302 that are spaced apart in the X-direction, and in some embodiments, additional openings (not shown) spaced apart in the Y-direction the surface area of the conductive material will increase, such that the conductive ink 1710 can form a desirable contact with portions of the photovoltaic device 100. This increased surface area increases the strength of the mechanical bond between the conductive materials, such as the conductive ink 1710, and the conductive walls 134. Furthermore, filling the openings 2102, 2202, 2302 with conductive material, such as conductive ink 1710 provides a larger conductive path for electrons to flow through the photovoltaic device 100 relative to embodiments in which the openings 2102, 2202, 2302 are not filled with a conductive material. This larger conductive path reduces the resistance between the back-contact layer 120 and the first busbar 180₁, which improves the efficiency of the photovoltaic apparatus.

A conductive layer 1700 can be disposed between the first busbar 180₁ and the vias 2100, 2200, 2300. In some embodiments, the conductive layer 1700 can underlie substantially all of the first busbar 180₁. In some embodiments, the conductive layer 1700 can have a width in the X-direction that is greater than the width in the X-direction of the first busbar 180₁ and/or a length in the Y-direction that is greater than the length in the Y-direction of the first busbar 180₁.

The conductive layer 1700 can include a first conductive layer 1710 disposed between the first busbar 180₁ and the vias 2100, 2200, 2300. The first conductive layer 1710 may be formed of a conductive ink or metal containing paste, such as a conductive silver (Ag) ink that can dry rapidly to form a flexible, conductive material. For example, in one embodiment, a metallic alloy can be used as the conductive ink. In some embodiments, a conductive ink that is hardened by heat, ultraviolet radiation, or flash pyrolysis may be used. For example, in another embodiment the conductive ink can be formed of a material having a sheet resistance of less than about 0.15 Ohms/square at a thickness of about 25 µm, such as Electrodag^{®}, a trademark of the Henkel Corporation. The first conductive layer 1710 may further extend over the vias 2100-2300 and portions of the front-contact layer 150, so that the first conductive layer 1710 electrically connects the vias 2100-2300 to each other.

The conductive layer 1700 can further include a second conductive layer 1720 disposed between the first busbar 180₁ and the first conductive layer 1710. The second conductive layer 1720 can be formed of a conductive adhesive, such as a conductive tape, such as a metal plated foil coated with an adhesive. In some embodiments, the conductive adhesive 1720 can be formed of a mixture of one or more metals (e.g., Ag, Ni, Au) and a polymer-based adhesive (e.g., a silicone or acrylic based adhesive). The polymer-based adhesive allows for a smooth and flexible connection between the first busbar 180₁, which can be a hard metal, and the photovoltaic device 100. For example, in one embodiment Charge-Collection Solar Tape 3007 available from the 3M ^{™} Corporation may be used.

The following describes an exemplary sequence for installing the first busbar 180₁ in the photovoltaic apparatus 200. After, the photovoltaic device 100 is formed on the substrate 110, the openings 2102, 2202, 2302 may be formed through layers of the photovoltaic device 100, such as the absorber layer 130 using the laser scribing process described above. Next, the conductive ink 1710 can be applied to fill the openings 2102, 2202, 2302 and to coat at least a portion of the front-contact layer 150. The conductive ink 1710 can be hardened by use of heat, ultraviolet radiation, or a galvanic tampon process. Then, the conductive adhesive 1720 can be provided over the conductive ink 1710. Next, the first busbar 180₁ and the busbar at the opposing end of the photovoltaic device may be positioned on the conductive adhesive 1720. After, the remaining layers and components, such as the adhesive layers 230, 240 and the front sheet 250 (see Figure 1B), are added, the structure can be laminated to form the photovoltaic apparatus 200 shown in Figures 1A and 1B.

The first busbar 180₁ may be disposed over the second conductive layer 1720. The first busbar 180₁ may be formed of a variety of materials including metals, such as copper, nickel plated copper, silver plated copper, tin plated copper, steel, stainless steel, or other commonly used conductors. The first busbar 180₁ can have a width 1881 in the X-direction that is at least as wide as the distance 1180 between the first via 2100 and the last via 2300 in the X-direction described above. In some embodiments, the width 1881 can be from about 100 µm to about 3 cm, such as from about 2 mm to about 8 mm, such as from about 3 mm to about 5 mm. Furthermore, the first busbar 180 can have a thickness in the Z-direction from about 0.2 mm to about 5 mm, such as from about 0.5 mm to about 1.5 mm, such as from about 0.7 mm to about 1 mm.

In some embodiments, the first busbar 180₁ may be formed of a plurality of strands 1851 that may be woven together form a braided structure. For example, Figure 2A is shown including six separate clusters 1850 of strands 1851, where each cluster 1850 includes four strands 1851 and the six clusters 1850 are woven together to form the busbar 180₁. The clusters 1850 and strands 1851 are not shown in Figures 2B-2D, and the diagonal lines in the busbar 180₁ in these Figures is a cross-hatch that is used for illustrative purposes and is not intended to show the orientation of the wire strands. In other embodiments, more or fewer clusters 1850 may be used, and more or fewer strands 1851 may be used within the clusters 1850. Furthermore, in some embodiments the individual strands 1851 may be woven together without the use of the clusters 1850.

Conventional flat busbars generally have a length that extends in one direction, for example the Y-direction in Figure 1B. Because the length of these busbars is much greater than the width (X-direction) or the thickness (Z-direction) the length can expand and contract greatly relative to changes in the X and Z-direction during periods where the photovoltaic apparatus 200 is stressed, which can cause deformations of the photovoltaic apparatus, such as bumps, wrinkles and delamination. Using a braided structure for the first busbar 180₁ allows each strand 1851 to have a length that extends in the X and Z-directions as well as the Y-direction enabling 3-dimensional stress compensation. This allows for more of the stress created by the expansions and contractions of the busbar 180₁ to be absorbed in the X and Z-directions and less of the stress to be absorbed in the Y-direction, which allows for a more even distribution of stresses than conventional flat ribbon type busbars. Thus, using the busbar 180₁ can reduce the amount of stress and deformation created within a photovoltaic apparatus that is caused by thermal and other stresses. Furthermore, the strands 1851 of the first busbar 180₁ make the first busbar 180₁ much more flexible than conventional flat busbars. The increased flexibility of the first busbar 180₁ further serves to prevent larger stresses from accumulating in the first busbar 180₁, such as stresses large enough to cause deformations of the photovoltaic apparatus.

The busbar 180₁ may further include a first portion 1810 overlying the first via 2100, a second portion 1820 overlying the second via 2200, and a third portion 1830 overlying the third via 2300. The first portion 1810 can include a first surface 1811 electrically connecting the first portion 1810 to the first via 2100. The second portion 1820 can include a second surface 1821 electrically connecting the second portion 1820 to the second via 2200. The third portion 1830 can include a third surface 1831 electrically connecting the third portion 1830 to the third via 2300. The surfaces 1811, 1821, 1831 can be convex surfaces of the respective portions 1810, 1820, 1830. The surfaces 1811, 1821, 1831 can contact the second conductive layer 1720 to make the electrical connections between the respective portions 1810, 1820, 1830 and the respective vias 2100, 2200, 2300. The first busbar 180₁ may be spaced apart from the second conductive layer 1720 along portions of the first busbar 1801 not overlying the vias, such as the vias 2100, 2200, 2300. Having convex surfaces 1811, 1821, 1831 of the first busbar 180₁ directly overlying the vias 2100, 2200, 2300 reduces the distance electrons must travel between the first busbar 180₁ and the back-contact layer 120, which reduces the resistance between the first busbar 180₁ and the back-contact layer 120 and raises the efficiency of the photovoltaic apparatus 200. Furthermore, the woven structure of the first busbar 180₁ causes electrical contact between many of the strands 1851 and the conductive layer 1700, creating a relatively homogenous flow of current through the busbar, which can help prevent occurrences of excessive temperatures on portions of a busbar subjected to high current.

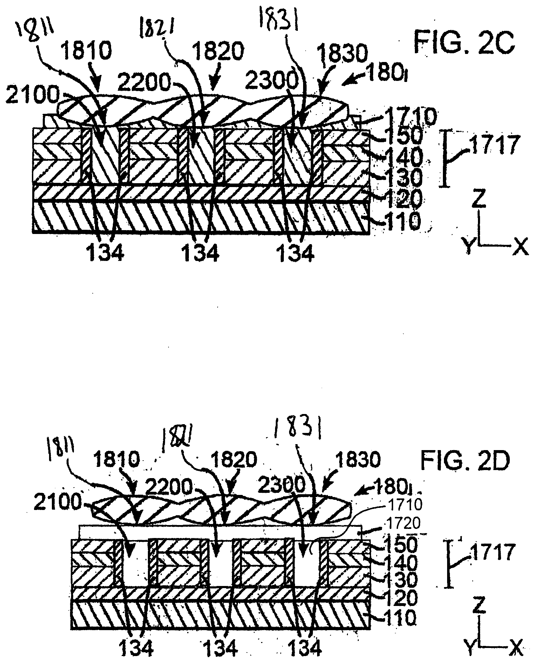

Figure 2C is an alternative side sectional view along the section line 2-2 of Figure 2A, according to one embodiment. The embodiment shown in Figure 2C is the same as the embodiment shown in Figure 2B except that the embodiment shown in Figure 2C does not include the second conductive layer 1720. In the embodiment of Figure 2C, the first busbar 180 is embedded in or bonded to the first conductive layer 1710. Furthermore, the surfaces 1811, 1821, 1831 of the first busbar 180₁ may contact respective vias 2100, 2200, 2300.

Figure 2D is an alternative side sectional view along the section line 2-2 of Figure 2A, according to one embodiment. The embodiment shown in Figure 2D is the same as the embodiment shown in Figure 2B except that the embodiment shown in Figure 2D does not include the first conductive layer 1710. In the embodiment of Figure 2D, the first busbar 180 can be disposed on the second conductive layer 1720 and the second conductive layer 1720 may be disposed directly on the vias 2100, 2200, 2300.

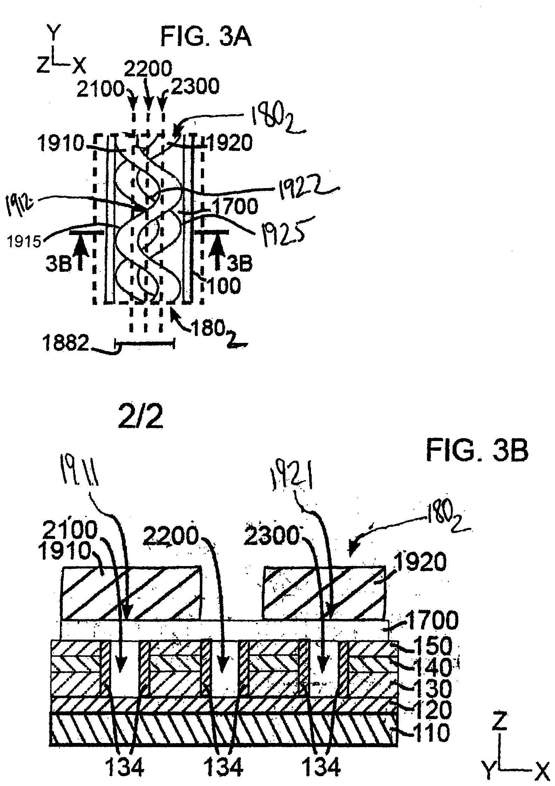

Figure 3A is a top view of the dashed box 1 of Figure 1B that includes a second embodiment of the first busbar 180 shown here as first busbar 180₂, according to one embodiment. Figure 3B is a side sectional view along the section line 3B of Figure 3A, according to one embodiment.

The second embodiment of the first busbar 180₂ includes a first wavy conductor 1910 and a second wavy conductor 1920. In some embodiments, the wavy conductors 1910, 1920 can be formed by cutting a flat conductor, such as flat metal conductor, in the shape of a wave. In some embodiments, the wavy conductors 1910, 1920 may be intertwined, such as being arranged in a twisted-pair. Furthermore, for embodiments including three or more wavy conductors, the wavy conductors may be included and in some embodiments the three or more conductors can be braided.

The first wavy conductor 1910 can include a series of peaks 1915 in the X-direction, where the peaks 1915 are spaced apart at intervals in the Y-direction defined by a first period. Similarly, the second wavy conductor 1920 can include a series of peaks 1925 in the X-direction, where the peaks 1925 are spaced apart at intervals in the Y-direction defined by a second period. The wavy conductors 1910, 1920 may be stacked on top of each other in an arrangement that causes a phase shift between the peaks 1915, 1925 of the wavy conductors 1910, 1920. In some embodiments, the phase shift between the first period and the second period is shifted at a multiple other than a quarter of one of the periods of the wavy conductors 1910, 1920 so as to increase the number of vias holes that are overlapped by the wavy conductors 1910, 1920 as the first busbar 180₂ extends in the Y-direction. Each wavy conductor 1910, 1920 can have a width 1882 in the X-direction (i.e., the distance between peaks of the wavy conductor in the ±X-direction) that is at least as wide as the distance 1180 (Figure 2A) between the first via 2100 and the last via 2300 described above. In some embodiments, the width 1882 can be from about 100 µm to about 3 cm, such as from about 2 mm to about 8 mm, such as from about 3 mm to about 5 mm.

The first wavy conductor 1910 may include a first surface 1911 disposed on the conductive layer 1700. The first surface 1911 may overlie portions of each of the vias 2100, 2200, 2300 as the first surface 1911 extends in the Y-direction. Furthermore, a given section of the first surface 1911 in the Y-direction may overlie two or more of the vias 2100, 2200, 2300 at that location in the Y-direction.

The second wavy conductor 1920 may include a second surface 1921 disposed on the conductive layer 1700. The second surface 1921 may overlie portions of each of the vias 2100, 2200, 2300 as the second surface 1921 extends in the Y-direction. Furthermore, a given section of the second surface 1921 in the Y-direction may overlie two or more of the vias 2100, 2200, 2300 at that location and the Y-direction.

Using one or more wavy conductors 1910, 1920 for the first busbar 180₂ have a length that extends in the X-direction as well as the Y-direction. This allows for more of the thermal stress of the expansions and contractions of the busbar 180₂ to be absorbed in the X-direction and less of the stress to be absorbed in the Y-direction relative to a conventional flat busbar, such as a rectangular busbar.

The first wavy conductor 1910 can include a series of peaks 1915 in the X-direction and a series of inflection points 1912 between the peaks 1915. Similarly, the second wavy conductor 1920 can include a series of peaks 1925 in the X-direction and a series of inflection points 1922 between the peaks 1925. The inflection points 1912 of the first wavy conductor 1910 may be located closer to a portion of the second wavy conductor 1920 than peaks 1915 are to any portion of the second wavy conductor. Similarly, the inflection points 1922 of the second wavy conductor 1920 may be located closer to a portion of the first wavy conductor 1910 than the peaks 1925 are to any portion of the first wavy conductor 1910. By arranging the peaks 1915, 1925 and inflection points 1912, 1922 of each wavy conductor 1910, 1920 in this way, regions of strong adhesion and weaker adhesion to the conductive layer 1700 may be created at various points along the length of each of the wavy conductors 1910, 1920. For example, because the peaks 1915 of the first wavy conductor 1910 are positioned further away from portions of the second wavy conductor 1920 than the inflections points 1912 are to the second wavy conductor, the portions of the first wavy conductor 1910 including the peaks 1915 are more strongly adhered to the conductive layer 1700 than the portions of the first wavy conductor 1910 including the inflection points 1912. Due to the position of the inflection points 1912, 1922, or by design of the coupling of the first and second wavy conductors 1910, 1920 to the conductive layer 1700, the portions of the first and second wavy conductors 1910, 1920 are more weakly adhered to the conductive layer 1700 than the portions including the peaks 1915, 1925. Therefore, environmental stress (e.g., thermal stresses) induced loads created between two areas of strong adhesion, such as the peaks of one of the wavy conductors, of a busbar 180₂ can result in a torque created within the first and second wavy conductors 1910, 1920 in areas where there is weaker or reduced adhesion (i.e., the inflection points) to the conductive layer 1700. The generated torque can result in the induced stress being diminished by the deflection of the busbar 180₂ in the X and/or Z-directions, as opposed to the Y-direction, thus allowing for the overall stress to be reduced in the Y-direction relative to conventional flat busbars.

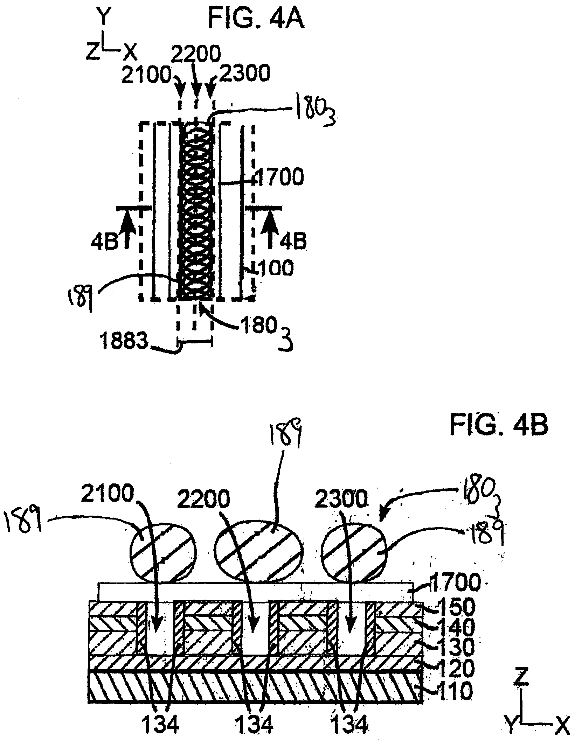

Figure 4A is a close-up top view of the dashed box 1 of Figure 1B that includes a third embodiment of the first busbar 180 shown here as first busbar 180₃, according to one embodiment. Figure 4B is a side sectional view along the section line 4B of Figure 4A, according to one embodiment.

The third embodiment of the first busbar 180₃ is a flattened spiral conductor. The first busbar 180₃ can be formed of one or more wires that form a plurality of loops 189 to make the flattened spiral. The plurality of loops 189 may be oriented to partially overlap each other as the first busbar 180₃ extends in the Y-direction. The busbar 180₃ can have a thickness in the Z-direction from about 0.1 mm to about 0.5 mm. The loops 189 may be arranged so that a surface of one of the loops 189 is disposed over each of the vias 2100, 2200, 2300 including all of the vias at different locations in the Y-direction. The loops 189 can have a width 1883 in the X-direction that is the same as or slightly greater than the distance 1180 (Figure 2B) between the first via 2100 and the third via 2300 described above. Thus, the edges of the loops 189 in the X-direction may be disposed over the first via 2100 and the third via 2300 so that all or substantially all of the lengths of the first via 2100 and the third via 2300 in the Y-direction are covered by a portion of the loops 189 ensuring a low resistance electrical contact between the first busbar 180₃ and the vias 2100, 2300. Furthermore, for embodiments including a series of vias spaced apart in the Y-direction, loops 189 may be arranged so that a portion of one or more loops 189 overlies each second via 2200 along the length of the busbar 180₃ in the Y-direction.

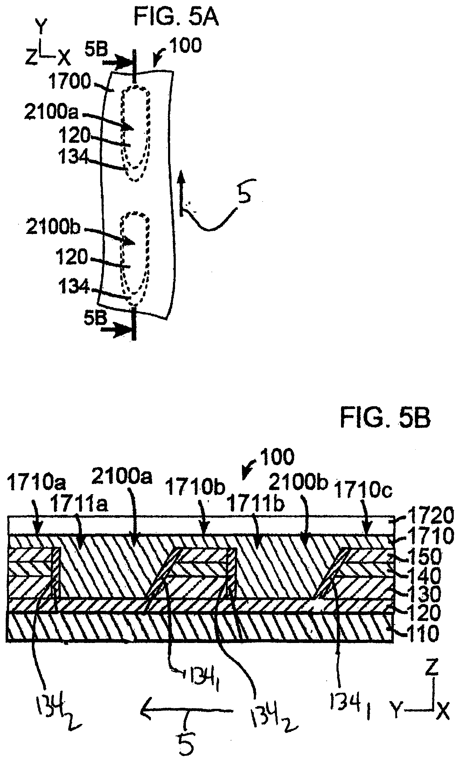

Figure 5A is a partial top view of two vias 2100a, 2100b that may be included in the photovoltaic apparatus 200, according to one embodiment. Figure 5B is a side sectional view of the photovoltaic apparatus 200 along the section line 5B-5B of Figure 5A, according to one embodiment. The direction 5 indicates the direction in which the laser is translated over the photovoltaic device 100 to form the vias 2100a, 2100b during the laser scribing process. Each via 2100a, 2100b includes a first conductive wall 134₁ and a second conductive wall 134₂. The first conductive wall 134₁ is the conductive wall 134 that is formed when the laser is first energized to form the respective via 2100a, 2100b. The first conductive wall 134₁ is sloped in the Y-direction. The second conductive wall 134₂ is the conductive wall 134 that is formed when the laser is de-energized as the respective via 2100a, 2100b is finished being formed. The second conductive wall 134₂ has less of a slope in the Y-direction relative to the first conductive wall 134₁. The slope of the first conductive wall 134₁ can facilitate thermal expansion of the first conductive layer 1710 and can serve to distribute stresses and strains between portions of the first conductive layer 1710 disposed in the vias 2100 and over the vias 2100, which can reduce occurrences of cracks or other deformations in the first conductive layer 1710 or other layers caused by expansions or contractions in the Y-direction and/or flexing in the X-direction.

The first conductive layer 1710 includes a first portion 1711a forming the first via 2100a and a second portion 1711b forming the second via 2100b. The first conductive layer 1710 further includes portions 1710a, 1710b, 1710c overlying portions of the front-contact layer 150. The first portions 1711a and the second portion 1711b are strongly supported by the conductive walls 134₁, 134₂ to resist stresses in the X and Y-directions while the portions 1710a, 1710b, 1710c are less supported to resist stresses in the X and Y-directions. Therefore, portions of the first conductive layer 1710 overlying the front-contact layer 150 between vias 2100 can act as distributed zones of strain release that can prevent large stresses from accumulating that can cause large deformations that can damage the photovoltaic apparatus.

While the foregoing is directed to embodiments of the present disclosure, other and further embodiments of the disclosure may be devised without departing from the basic scope thereof, and the scope thereof is determined by the claims that follow.

## Claims

1. A photovoltaic apparatus (200) comprising:
a photovoltaic device (100) comprising:
an array of photovoltaic cells (101-114) having a first end (1101) and a second end (1102), the array extending in a first direction from the first end to the second end; each photovoltaic cell comprising:
a first contact layer (150);
a second contact layer (120); and
an absorber layer (130) disposed between the first contact layer
and the second contact layer; and
a first busbar (180) extending from a first side of the photovoltaic device to a second side of the photovoltaic device in a second direction,
**characterised in that**
the first busbar includes a plurality of strands (1851) that form a braided structure.

2. The photovoltaic apparatus of claim 1, further comprising a plurality of vias (2100, 2200, 2300) extending through the absorber layer, wherein each via electrically connects the first busbar to the second contact layer.

3. The photovoltaic apparatus of claim 2, wherein each via is disposed between the first busbar and the second contact layer.

4. The photovoltaic apparatus of claim 2, wherein the plurality of vias includes two or more vias spaced apart in the first direction and the first busbar includes a convex surface overlying each of the two or more vias .

5. The photovoltaic apparatus of claim 2, further comprising a conductive ink (1710) that is disposed within the plurality of vias.

6. The photovoltaic apparatus of claim 2, further comprising a conductive adhesive disposed between the first busbar and the vias.

7. The photovoltaic apparatus of claim 2, wherein each via of the plurality of vias extends through an opening (2102, 2202, and 2302) through the absorber layer and each opening includes at least one wall (134) that is sloped in the second direction.

8. A photovoltaic apparatus (200) comprising:
a photovoltaic device (100) comprising:
an array of photovoltaic cells (101-114) having a first end (1101) and a second end (1102), the array extending in a first direction from the first end to the second end; each photovoltaic cell comprising:
a first contact layer (150);
a second contact layer (120); and
an absorber layer (130) disposed between the first contact layer
and the second contact layer; and
a first busbar (180) extending from a first side of the photovoltaic device to a second side of the photovoltaic device in a second direction,
**characterised in that**
the first busbar includes one or more wavy conductors (1910, 1920), each wavy conductor having a series of peaks (1915) in the first direction,
wherein the one or more wavy conductors comprises a first wavy conductor (1910) and a second wavy conductor (1920) stacked on top of each other in an arrangement that causes a phase shift between the peaks (1915, 1925) of the wavy conductors (1910, 1920).

9. The photovoltaic apparatus of claim 8, wherein the series of peaks (1915) of the first wavy conductor are regularly spaced at intervals that are defined by a first period, the series of peaks (1925) of the second wavy conductor are regularly spaced at intervals that are defined by a second period, and the series of peaks of the first wavy conductor is offset from the series of peaks of the second wavy conductor by other than a multiple of one quarter the second period.

10. The photovoltaic apparatus of claim 8, further comprising a plurality of vias (2100, 2200, 2300) extending through the absorber layer, wherein each via electrically connects the first busbar to the second contact layer.

11. The photovoltaic apparatus of claim 10, wherein each via is disposed between the first busbar and the second contact layer.

12. The photovoltaic apparatus of claim 10, wherein the plurality of vias includes two or more vias spaced apart in the first direction and the first wavy conductor includes a first surface overlying one or more of the vias spaced apart in the first direction.

13. The photovoltaic apparatus of claim 10, wherein each via of the plurality of vias extends through an opening (2102, 2202, and 2302) through the absorber layer and each opening includes at least one wall (134) that is sloped in the second direction.

14. A photovoltaic apparatus (200) comprising:
a photovoltaic device (100) comprising:
an array of photovoltaic cells (101-114) having a first end (1101) and a second end (1102), the array extending in a first direction from the first end to the second end; each photovoltaic cell comprising:
a first contact layer (150) ;
a second contact layer (120) ; and
an absorber layer (130) disposed between the first contact layer
and the second contact layer; and
a first busbar (180) extending from a first side of the photovoltaic device to a second side of the photovoltaic device in a second direction,
**characterised in that**
the first busbar includes one or more wire that each forms one or more loop (189).

15. The photovoltaic apparatus of claim 14, wherein the loops formed by the one or more wires are oriented to partially overlap each other as the first busbar extends in the second direction.

## Patentansprüche

1. Photovoltaische Vorrichtung (200) mit :
eine photovoltaische Vorrichtung (100) mit:
eine Anordnung von photovoltaischen Zellen (101-114) mit einem ersten Ende (1101) und einem zweiten Ende (1102), wobei sich die Anordnung in einer ersten Richtung von dem ersten Ende zu dem zweiten Ende erstreckt; jede photovoltaische Zelle umfasst:
eine erste Kontaktschicht (150) ;
eine zweite Kontaktschicht (120); und
eine absorbierende Schicht (130), die zwischen der ersten Kontaktschicht und der zweiten Kontaktschicht angeordnet ist; und
eine erste Sammelschiene (180), die sich von einer ersten Seite der photovoltaischen Vorrichtung zu einer zweiten Seite der photovoltaischen Vorrichtung in einer zweiten Richtung erstreckt
**dadurch gekennzeichnet, dass**
die erste Sammelschiene eine Vielzahl von Strängen (1851) umfasst, die eine geflochtene Struktur bilden.

2. Photovoltaische Vorrichtung nach Anspruch 1, ferner umfassend eine Vielzahl von Durchkontaktierungen (2100, 2200, 2300), die sich durch die absorbierende Schicht erstrecken, wobei jede Durchkontaktierung die erste Sammelschiene mit der zweiten Kontaktschicht elektrisch verbindet.

3. Photovoltaische Vorrichtung nach Anspruch 2, wobei jedes Durchkontaktierung zwischen der ersten Sammelschiene und der zweiten Kontaktschicht angeordnet ist.

4. Photovoltaische Vorrichtung nach Anspruch 2, wobei die Vielzahl von Durchkontaktierungen zwei oder mehr Durchkontaktierungen umfasst, die in der ersten Richtung beabstandet sind, und die erste Sammelschiene eine konvexe Oberfläche umfasst, die jede der zwei oder mehr Durchkontaktierungen bedeckt.

5. Photovoltaische Vorrichtung nach Anspruch 2, ferner umfassend eine leitfähige Tinte (1710), die innerhalb der Vielzahl von Durchkontaktierungen angeordnet ist.

6. Photovoltaische Vorrichtung nach Anspruch 2, ferner umfassend einen leitfähigen Klebstoff umfasst, der zwischen der ersten Sammelschiene und den Durchkontaktierungen angeordnet ist.

7. Photovoltaische Vorrichtung nach Anspruch 2, wobei sich jedes Durchkontaktierung der Vielzahl von Durchkontaktierungen durch eine Öffnung (2102, 2202 und 2302) durch die absorbierende Schicht erstrecktund jede Öffnung mindestens eine Wand (134) umfasst, die in der zweiten Richtung geneigt ist.

8. Photovoltaische Vorrichtung (200) mit:
eine photovoltaische Vorrichtung (100) mit:
eine Anordnung von photovoltaischen Zellen (101-114) mit einem ersten Ende (1101) und einem zweiten Ende (1102), wobei sich die Anordnung in einer ersten Richtung von dem ersten Ende zu dem zweiten Ende erstreckt; jede photovoltaische Zelle umfasst:
eine erste Kontaktschicht (150) ;
eine zweite Kontaktschicht (120); und
eine absorbierende Schicht (130), die zwischen der ersten Kontaktschicht und der zweiten Kontaktschicht angeordnet ist; und
eine erste Sammelschiene (180), die sich von einer ersten Seite der photovoltaischen Vorrichtung zu einer zweiten Seite der photovoltaischen Vorrichtung in einer zweiten Richtung erstreckt
**dadurch gekennzeichnet, dass**
die erste Sammelschiene einen oder mehrere gewellte Leiter (1910, 1920) umfasst, wobei jeder gewellte Leiter eine Reihe von Spitzen (1915) in der ersten Richtung aufweist,
wobei der oder die gewellten Leiter einen ersten gewellten Leiter (1910) und einen zweiten gewellten Leiter (1920) umfassen, die in einer Anordnung übereinander gestapelt sind, die eine Phasenverschiebung zwischen den Spitzen (1915, 1925) der gewellten Leiter (1910, 1920) bewirkt.

9. Photovoltaische Vorrichtung nach Anspruch 8, wobei die Reihe von Spitzen (1915) des ersten gewellten Leiters regelmäßig in Intervallen beabstandet ist, die durch eine erste Periode definiert sind, die Reihe von Spitzen (1925) des zweiten gewellten Leiters regelmäßig in Intervallen beabstandet ist, die durch eine zweite Periode definiert sind, und die Reihe von Spitzen des ersten gewellten Leiters von der Reihe von Spitzen des zweiten gewellten Leiters um etwas anderes als ein Vielfaches von einem Viertel der zweiten Periode verschoben ist

10. Photovoltaische Vorrichtung nach Anspruch 8, ferner umfassend eine Vielzahl von Durchkontaktierungen (2100, 2200, 2300), die sich durch die absorbierende Schicht erstrecken, wobei jede Durchkontaktierung die erste Sammelschiene mit der zweiten Kontaktschicht elektrisch verbindet.

11. Photovoltaische Vorrichtung nach Anspruch 10, wobei jedes Durchkontaktierung zwischen der ersten Sammelschiene und der zweiten Kontaktschicht angeordnet ist.

12. Photovoltaische Vorrichtung nach Anspruch 10, wobei die Vielzahl von Durchkontaktierungen zwei oder mehr Durchkontaktierungen umfasst, die in der ersten Richtung beabstandet sind, und der erste gewellte Leiter eine erste Oberfläche umfasst, die eine oder mehrere der in der ersten Richtung beabstandeten Durchkontaktierungen bedeckt.

13. Photovoltaische Vorrichtung nach Anspruch 10, wobei sich jedes Durchkontaktierung der Vielzahl von Durchkontaktierungen durch eine Öffnung (2102, 2202 und 2302) durch die absorbierende Schicht erstrecktund jede Öffnung mindestens eine Wand (134) umfasst, die in der zweiten Richtung geneigt ist.

14. Photovoltaische Vorrichtung (200) mit:
eine photovoltaische Vorrichtung (100) mit:
eine Anordnung von photovoltaischen Zellen (101-114) mit einem ersten Ende (1101) und einem zweiten Ende (1102), wobei sich die Anordnung in einer ersten Richtung von dem ersten Ende zu dem zweiten Ende erstreckt; jede photovoltaische Zelle umfasst:
eine erste Kontaktschicht (150) ;
eine zweite Kontaktschicht (120); und
eine absorbierende Schicht (130), die zwischen der ersten Kontaktschicht und der zweiten Kontaktschicht angeordnet ist; und
eine erste Sammelschiene (180), die sich von einer ersten Seite der photovoltaischen Vorrichtung zu einer zweiten Seite der photovoltaischen Vorrichtung in einer zweiten Richtung erstreckt
**dadurch gekennzeichnet, dass**
die erste Sammelschiene einen oder mehrere Drähte umfasst, die jeweils eine oder mehrere Schleifen (189) bilden.

15. Photovoltaikgerät nach Anspruch 14, wobei die durch den Draht oder die Drähte gebildeten Schleifen so ausgerichtet sind, dass sie sich teilweise überlappen, wenn sich die erste Sammelschiene in die zweite Richtung erstreckt.

## Revendications

1. Appareil photovoltaïque (200) comprenant :
un dispositif photovoltaïque (100) comprenant :
un réseau de cellules photovoltaïques (101-114) ayant une première extrémité (1101) et une seconde extrémité (1102), le réseau s'étendant dans une première direction de la première extrémité à la seconde extrémité ; chaque cellule photovoltaïque comprenant :
une première couche de contact (150) ;
une deuxième couche de contact (120) ; et
une couche absorbante (130) disposée entre la première couche de contact et la seconde couche de contact ; et
une première barre omnibus (180) s'étendant d'un premier côté du dispositif photovoltaïque à un second côté du dispositif photovoltaïque dans une seconde direction,
**caractérisé en ce que**
la première barre omnibus comprend une pluralité de brins (1851) qui forment une structure tressée.

2. Appareil photovoltaïque selon la revendication 1, comprenant en outre une pluralité de vias (2100, 2200, 2300) s'étendant à travers la couche absorbante, dans lequel chaque via connecte électriquement la première barre omnibus à la seconde couche de contact.

3. Appareil photovoltaïque de la revendication 2, dans lequel chaque via est disposé entre la première barre omnibus et la seconde couche de contact.

4. Appareil photovoltaïque de la revendication 2, dans lequel la pluralité de vias comprend deux vias ou plus espacés dans la première direction et la première barre omnibus comprend une surface convexe recouvrant chacun des deux vias ou plus.

5. Appareil photovoltaïque de la revendication 2, comprenant en outre une encre conductrice (1710) qui est disposée à l'intérieur de la pluralité de vias.

6. Appareil photovoltaïque de la revendication 2, comprenant en outre un adhésif conducteur disposé entre la première barre omnibus et les vias.

7. Appareil photovoltaïque selon la revendication 2, dans lequel chaque via de la pluralité de vias s'étend à travers une ouverture (2102, 2202 et 2302) à travers la couche absorbante et chaque ouverture comprend au moins une paroi (134) qui est inclinée dans la deuxième direction.

8. Appareil photovoltaïque (200) comprenant :
un dispositif photovoltaïque (100) comprenant :
un réseau de cellules photovoltaïques (101-114) ayant une première extrémité (1101) et une seconde extrémité (1102), le réseau s'étendant dans une première direction de la première extrémité à la seconde extrémité ; chaque cellule photovoltaïque comprenant :
une première couche de contact (150) ;
une deuxième couche de contact (120) ; et
une couche absorbante (130) disposée entre la première couche de contact et la seconde couche de contact ; et
une première barre omnibus (180) s'étendant d'un premier côté du dispositif photovoltaïque à un second côté du dispositif photovoltaïque dans une seconde direction,
**caractérisé en ce que**
la première barre omnibus comprend un ou plusieurs conducteurs ondulés (1910, 1920), chaque conducteur ondulé ayant une série de pics (1915) dans la première direction,
dans lequel le ou les conducteurs ondulés comprennent un premier conducteur ondulé (1910) et un second conducteur ondulé (1920) empilés l'un sur l'autre selon une disposition qui provoque un déphasage entre les pics (1915, 1925) des conducteurs ondulés (1910, 1920).

9. Appareil photovoltaïque selon la revendication 8, dans lequel la série de pics (1915) du premier conducteur ondulé est régulièrement espacée à des intervalles qui sont définis par une première période, la série de pics (1925) du second conducteur ondulé est régulièrement espacée à des intervalles qui sont définis par une seconde période, et la série de pics du premier conducteur ondulé est décalée de la série de pics du second conducteur ondulé par autre chose qu'un multiple d'un quart de la seconde période.

10. Appareil photovoltaïque selon la revendication 8, comprenant en outre une pluralité de vias (2100, 2200, 2300) s'étendant à travers la couche absorbante, dans lequel chaque via connecte électriquement la première barre omnibus à la seconde couche de contact.

11. Appareil photovoltaïque de la revendication 10, dans lequel chaque via est disposé entre la première barre omnibus et la seconde couche de contact.

12. Appareil photovoltaïque selon la revendication 10, dans lequel la pluralité de vias comprend deux vias ou plus espacés dans la première direction et le premier conducteur ondulé comprend une première surface recouvrant un ou plusieurs des vias espacés dans la première direction.

13. Appareil photovoltaïque selon la revendication 10, dans lequel chaque via de la pluralité de vias s'étend à travers une ouverture (2102, 2202 et 2302) à travers la couche absorbante et chaque ouverture comprend au moins une paroi (134) qui est inclinée dans la seconde direction.

14. Appareil photovoltaïque (200) comprenant :
un dispositif photovoltaïque (100) comprenant :
un réseau de cellules photovoltaïques (101-114) ayant une première extrémité (1101) et une seconde extrémité (1102), le réseau s'étendant dans une première direction de la première extrémité à la seconde extrémité ; chaque cellule photovoltaïque comprenant :
une première couche de contact (150) ;
une deuxième couche de contact (120) ; et
une couche absorbante (130) disposée entre la première couche de contact et la seconde couche de contact ; et
une première barre omnibus (180) s'étendant d'un premier côté du dispositif photovoltaïque à un second côté du dispositif photovoltaïque dans une seconde direction,
**caractérisé en ce que**
la première barre omnibus comprend un ou plusieurs fils qui forment chacun une ou plusieurs boucles (189).

15. Appareil photovoltaïque selon la revendication 14, dans lequel les boucles formées par le ou les fils sont orientées pour se chevaucher partiellement lorsque la première barre omnibus s'étend dans la seconde direction
